**Europäisches Patentamt**

**European Patent Office**

**Office européen des brevets**

(19)

(11) Veröffentlichungsnummer: **0 307 989**
**A2**

(12) # EUROPÄISCHE PATENTANMELDUNG

(21) Anmeldenummer: **88201866.6**

(22) Anmeldetag: **01.09.88**

(51) Int. Cl.⁴: **G01R 33/20**

(30) Priorität: **10.09.87 DE 3730293**

(43) Veröffentlichungstag der Anmeldung:
**22.03.89 Patentblatt 89/12**

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB NL**

(72) Erfinder: **Kuhn, Michael Harald, Dr.**
**Süntelstrasse 77**
**D-2000 Hamburg 61(DE)**
Erfinder: **Proksa, Roland**
**Zum Jägerfeld 8**
**D-2000 Hamburg 90(DE)**
Erfinder: **Helzel, Thomas**
**Oersdorfer Stieg 18**
**D-2358 Kaltenkirchen(DE)**
Erfinder: **van den Berg, Noel J.M.**
**Hogebergdreef 58**
**NL-4645 EX Putte(NL)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) **Kernresonanz-Spektrometer.**

(57) Die Erfindung betrifft ein Kernresonanz-Spektrometer bei dem zumindest im Empfangszweig die Frequenz des empfangenen Kernresonanzsignales in zwei Mischprozessen auf eine Frequenz oberhalb des Basisbandes in ein digitales Signal umgesetzt wird durch einen Analog-Digital-Wandler.

EP 0 307 989 A2

Fig.3

3a

3b

3c

## Kernresonanz-Spektrometer

Die Erfindung betrifft ein Kernresonanz-Spektrometer, bei dem im Empfangszweig zur Umsetzung der Kernresonanzsignale in einen niedrigeren Frequenzbereich wenigstens zwei Mischstufen vorgesehen sind, und bei dem ein Analog-Digital-Wandler die in den niedrigeren Frequenzbereich umgesetzten Kernresonanzsignale in eine Folge von digitalen Datenworten umwandelt, wobei die Abtastfrequenz mindestens doppelt so hoch ist wie die höchste Frequenz in dem umgesetzten Kernresonanzsignal.

Ein solches Spektrometer ist aus der DE-OS 2 928 551, insbesondere Fig. 13 bekannt. Bei jedem Mischvorgang in einem Spektrometer werden nicht nur die Signale aus dem Nutzfrequenzbereich in den Frequenzbereich des Ausgangssignales umgesetzt, sondern auch Signale aus dem Spiegelfrequenzbereich. (Die Spiegelfrequenz ist bekanntlich diejenige Frequenz, die von der Mischfrequenz mit der die Nutzfrequenz gemischt wird, den gleichen Frequenzabstand hat, wie die Nutzfrequenz). Die Rausch- und Störsignale im Spiegelfrequenzbereich müssen daher durch ein im Signalpfad vor der Mischstufe angeordnetes Filter unterdrückt werden. Die Anforderungen an dieses Filter sind bei dem bekannten Spektrometer verhältnismäßig gering, weil die erste Frequenz, mit der das Kernresonanzsignal gemischt wird, wesentlich größer ist als die Lamorfrequenz, so daß der Spiegelfrequenzbereich durch ein Filter mit geringer Flankensteilheit unterdrückt werden kann.

In der zweiten Mischstufe wird das Ausgangssignal der ersten Mischstufe in das Basisband heruntergemischt. Zu diesem Zweck ist die zweite Mischstufe als Quadraturmischer ausgebildet, in dem das Ausgangssignal der ersten Mischstufe mit zwei um 90° gegeneinander versetzten Signalen multipliziert wird, deren Frequenz exakt den zeitlichen Mittelwert des Ausgangssignals der ersten Mischstufe entspricht. Durch diesen Mischvorgang wird vermieden, daß Störungen oder Rauschen die außerhalb des Frequenzbereiches des Kernresonanzsignales liegen, in das Basisband transponiert werden.

Dieser Vorteil wird jedoch mit einer Reihe von Nachteilen erkauft. Der Quadraturmischer muß exakt symmetrisch aufgebaut sein, und die Phasenverschiebung zwischen den beiden sinusförmigen Signalen muß exakt 90° betragen. Die Erfüllung dieser Forderungen bei einer analog arbeitenden Mischstufe ist verhältnismäßig aufwendig. Ein weiterer Nachteil ist, daß die niedrigste Nutzfrequenz im Basisband so niedrig liegt, daß zur Verstärkung des Ausgangssignales des Quadraturmischers ein Gleichspannungsverstärker herangezogen werden muß. Durch Arbeitspunktverschiebungen dieses Verstärkers ergibt sich eine störende Drift, die zu Rekonstruktionsfehlern bei der Weiterverarbeitung des Signals führt. Außerdem wirken sich im Basisband das niederfrequente 1/f-Rauschen (oft auch als Funkelrauschen bezeichnet) sowie Harmonische der Netzfrequenz besonders störend aus.

Es ist Aufgabe der vorliegenden Erfindung, ein Spektrometer der eingangs genannten Art so auszugestalten, daß die geschilderten, mit der Umsetzung in das Basisband verbundenen Schwierigkeiten vermieden werden, ohne daß durch die Mischvorgänge zusätzliches Rauschen in den Nutzfrequenzbereich transponiert wird und ohne daß der Aufwand für die Filter im Empfangszweig zu groß wird.

Diese Aufgabe wird erfindungsgemäß dadurch gelöst, daß in der ersten Mischstufe das Kernresonanzsignal mit einer ersten Frequenz gemischt wird, daß in der ersten Mischstufe das Kernresonanzsignal mit einer ersten Frequenz gemischt wird, die in der Nähe der Lamorfrequenz liegt und daß in einer auf die erste Mischstufe folgenden zweiten Mischstufe das Ausgangssignal der ersten Mischstufe mit einer zweiten Frequenz gemischt wird, die von der Differenzfrequenz abweicht und wesentlich kleiner ist als die erste Frequenz.

Bei dem erfindungsgemäßen Spektrometer wird durch die zwei (oder mehr) -malige Mischung das Nutzsignal nicht in das Basisband transponiert, sondern in einen höheren Frequenzbereich. Infolgedessen können im analogen Teil des Spektrometers gleichstrommäßig entkoppelte Stufen verwendet werden, so daß das Problem der Gleichspannungsdrift entfällt. Ebenso werden Störungen durch Oberwellen der Netzfrequenz und durch das sogenannte 1/f-Rauschen unterdrückt, weil der Nutzfrequenzbereich höher liegt als der Frequenzbereich dieser Störungen.

Durch die zweimalige Mischung kann das Nutzfrequenzband in einen Frequenzbereich umgesetzt werden, der von den derzeit auf dem Markt befindlichen Analog-Digital-Wandlern mit dem erforderlichen Auflösungsvermögen (15 bit!) noch verarbeitet werden kann, ohne daß außerhalb des Nutzfrequenzbandes befindliches Rauschen bzw. Störungen durch den zweifachen Mischvorgang im wesentlichen Maße in das Nutzfrequenzband transponiert werden, und ohne daß der dafür erforderliche Filteraufwand unverhältnismäßig hoch wird.

Eine Weiterbildung der Erfindung sieht vor, daß die zweite Frequenz für die zweite Mischstufe (und für etwaige weitere Mischstufen) höher liegt als die (jeweilige) Nutzfrequenz. In diesem Fall kann die Filterung am Eingang der Mischstufe mittels eines Tiefpasses (anstelle eines Bandpasses) erfolgen, der dann einerseits den Spiegelfrequenzbereich und andererseits die Summenfrequenz am Ausgang der vorangehenden Mischstufe unterdrückt.

In weiterer Ausgestaltung der Erfindung ist vorgesehen, daß im Sendezweig ein Signalgenerator vorgesehen ist, in dem ein Träger mit einer dritten Frequenz modelliert wird, die kleiner ist als die Hälfte der Abtastfrequenz des Analog-Digital-Wandlers und daß das Ausgangssignal des Signalgenerators mit den gleichen Frequenzen gemischt wird wie das Kernresonanzsignal im Empfangszweig. Diese Ausgestaltung ermöglicht es, die erste und die zweite Frequenz sowohl im Empfangszweig als auch Sendezweig zum Mischen zu benutzen.

In noch weiterer Ausgestaltung der Erfindung ist dabei vorgesehen, daß die erste und die zweite Frequenz sowie die Abtastfrequenz so gewählt sind, daß der Frequenzabstand zwischen der ersten bzw. der zweiten Frequenz und der höchsten noch zu übertragenden Signalfrequenz am Eingang des zugehörigen Mischers, dividiert durch die erste bzw. zweite Frequenz zumindest annähernd dem Frequenzabstand zwischen der Hälfte der Abtastfrequenz und der obersten vom Analog-Digital-Wandler noch umzusetzenden Signalfrequenz, dividiert durch die Hälfte der Abtastfrequenz, entspricht. Dadurch wird erreicht, daß die Anforderungen an die Flankensteilheit der an den Eingängen bzw. den Ausgängen der Mischstufen vorgesehenen Filter gleich sind, so daß sich insgesamt der geringste Filteraufwand ergibt.

Eine andere Ausgestaltung der Erfindung sieht vor, daß die die erste und die zweite Frequenz sowie die Abtastfrequenz liefernden Generatoren mit einem gemeinsamen Referenzoszillator synchronisiert sind. Dadurch wird erreicht, daß alle Frequenzen in einer festen Relation zueinander stehen, so daß Phasenrauschen weitgehend unterbunden wird.

Die Erfindung wird nachstehend anhand der Zeichnung näher erläutert. Es zeigen

Fig. 1 einen Kernspintomographen bei dem die Erfindung einsetzbar ist,

Fig. 2 das Blockschaltbild eines erfindungsgemäßen Spektrometers und

Fig. 3 die Spektren an verschiedenen Ein- und Ausgängen der Mischstufen.

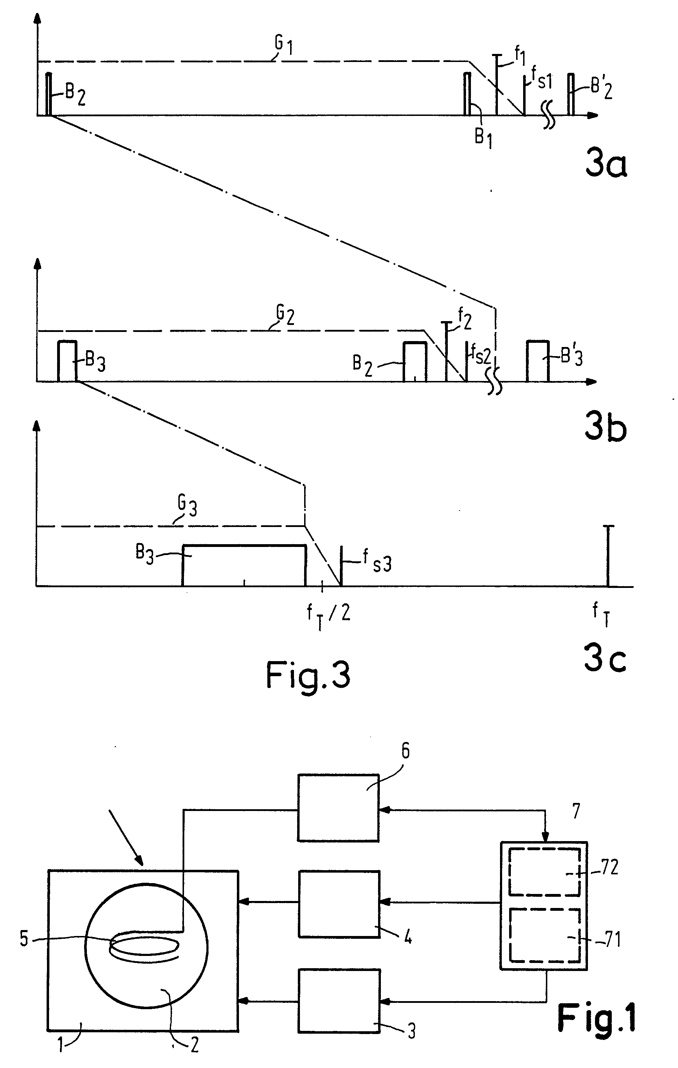

In Fig. 1 ist mit 1 eine Vorrichtung bezeichnet, die in einem Untersuchungsbereich 2 ein zur Zeichenebene senkrecht verlaufendes, homogenes und stationäres Magnetfeld von z.B. 0,5 T erzeugt und die bei Bedarf auch magnetische Gradientenfelder erzeugt, d.h. Magnetfelder, die in der gleichen Richtung verlaufen wie das stationäre homogene Magnetfeld, deren Stärke sich jedoch linear in Richtung des Magnetfeldes oder in einer dazu senkrechten Richtung ändert. Die Vorrichtung 1 ist zu diesem Zweck mit einem Generator 3 gekoppelt, der das stationäre Magnetfeld erzeugt und mit einem Generator 4, der die Ströme für die verschiedenen magnetischen Gradientenfelder liefert. Außerdem ist eine Hochfrequenzspule 5 vorgesehen, die ein zum stationären Magnetfeld senkrechtes, hochfrequentes Magnetfeld erzeugt und die an den Ausgang eines Spektrometers 6 angeschlossen ist. Das Spektrometer liefert im Sendebetrieb die Hochfrequenzenergie für die Hochfrequenzspule 5 und verarbeitet im Empfangsbetrieb die in dieser Spule induzierten Kernresonanzsignale.

Die Generatoren 3 und 4 und das Spektrometer 6 werden durch eine digitale Zentraleinheit 7 gesteuert, die zu diesem Zweck einen Steuerteil 71 enthält. Außerdem umfaßt die digitale Zentraleinheit einen Verarbeitungsteil 72, der die vom Spektrometer 6 gelieferten Daten verarbeitet und daraus die Kernmagnetisierungsverteilung im Untersuchungsbereich 2 rekonstruiert.

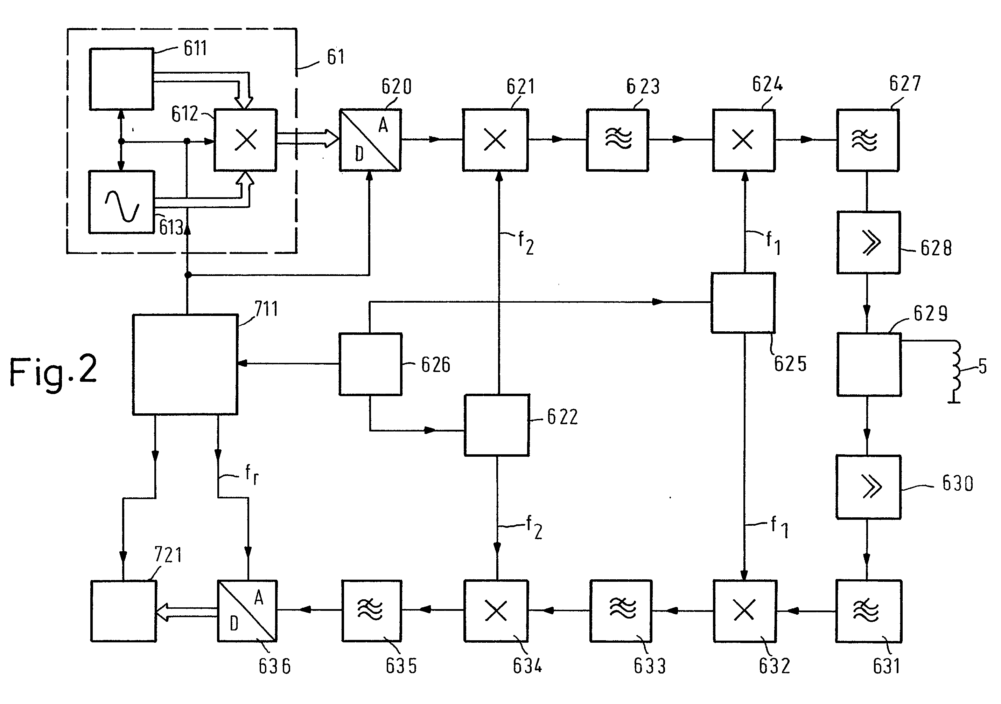

Gemäß Fig. 2 umfaßt das Spektrometer einen Signalgenerator 61, der an seinem Ausgang eine Folge von digitalen Datenworten liefert, die ein auf einen Träger von 102,45 KHz moduliertes Hüllkurvensignal darstellt. Das Hüllkurvensignal definiert den zeitlichen Verlauf der Umhüllenden des von der Spule 5 erzeugten Hochfrequenzimpulses. Es wird einem in dem Signalgenerator vorhandenen Hüllkurvenspeicher entnommen und in einem digitalen Multiplizierer 612 mit einem sinusförmigen Signal mit einer Trägerfrequenz von 102,45 KHz multipliziert. Dieses Signal wird einem Tabellenspeicher (Look-Up-Table) 613 entnommen, in dem eine Sinustabelle gespeichert ist. Die Taktfrequenz zum Auslesen der Speicher 611 und 613, die wesentlich höher ist als die Trägerfrequenz von 102,45 KHz, wird von einer Ablaufsteuereinheit 711 geliefert, die Teil der Steuereinheit 71 ist.

Das digitale Signal des Signalgenerators 61 wird einem Digital-Analog-Wandler 620 zugeführt. Das durch ein nicht näher dargestelltes Filter dargestellte analoge Ausgangssignal dieses Wandlers wird in einer Mischstufe 621 mit einem Signal gemischt, das von einem Frequenzsynthetisierer 622 erzeugt wird und dessen Frequenz $f_2$ bei 1,35 MHz liegt. Am Ausgang der Mischstufe 621 erscheint ein Differenzfrequenzband (um 1,24755 MHz) sowie ein Summenfrequenzband. Ein Tiefpaßfilter 623 läßt das Differenzfrequenzband durch und unterdrückt weitgehend das Summenfrequenzband. Das tiefpaßgefilterte Signal wird einer weiteren Mischstufe 624 zugeführt und dort mit einer Frequenz $f_1$ = 22,54 MHz gemischt.

Die Mischfrequenz $f_1$ wird durch einen Synthetisierer 625 erzeugt, der ebenso wie der Syntetisierer 622 durch einen bei z.B. 10 MHz schwingenden Referenzoszillator 626 synchronisiert wird. Durch diese Synchronisation wird ein Phasenrauschen weitgehend verhindert.

Das Ausgangssignal der Mischstufe 624 enthält wiederum ein Summenfrequenzband, das durch einen Tiefpaß 627 weitgehend unterdrückt wird und ein Differenzfrequenzband, das nach dem Durchlaufen des Tiefpasses 624 in einem Leistungsverstärker 628 verstärkt wird. Die Differenzfrequenz liegt bei 21,29245 MHz. Dies ist die Lamorfrequenz für Wasserstoffprotonen in einem stationären Magnetfeld von 0,5 T. Das Differenzfrequenzband wird über eine Umschalteinrichtung 629 der Hochfrequenzspule 5 zugeführt, die dadurch einen magnetischen Hochfrequenzimpuls erzeugt.

Im Empfangsbetrieb, d.h. nachdem der Untersuchungsbereich oder ein Teil davon durch einen oder mehrere Hochfrequenzimpulse angeregt worden ist, wird der Umschalter 629 umgeschaltet, so daß die in der Hochfrequenzspule 5 induzierten Kernresonanzsignale einem Vorverstärker 630 zugeführt werden. Die Frequenz der Kernresonanzsignale liegt um die Kernresonanzfrequenz (21,29245 MHz) herum, wobei die maximale Bandbreite der Kernresonanzsignale von der Größe des Untersuchungsbereiches und von dem Gradienten des magnetischen Gradientenfeldes abhängt; ein typischer Wert für die Bandbreite ist 60 KHz. Die oberste Nutzfrequenz, die in dem Vorverstärker 630 verstärkt wird, liegt also bei 21,32245 MHz.

Das Ausgangssignal des Vorverstärkers 630 wird über ein Filter 631 einem Eingang einer Mischstufe 632 zugeführt, deren anderem Mischeingang das Ausgangssignal des Synthetisierers 625 mit der Frequenz $f_1$ zugeführt wird.

In Fig. 3a sind die Spektren der Signale an den Ein- und Ausgängen der Mischstufe 632 dargestellt, wobei das Nutzfrequenzband mit $B_1$ bezeichnet ist. Durch den Mischvorgang ergibt sich ein Differenzfrequenzband $B_2$ und ein Summenfrequenzband $B'_2$. - Beim Mischvorgang werden nicht nur das Nutzfrequenzband, sondern auch Rauschen und andere Störungen im Spiegelfrequenzband in die Bänder $B_2$ bzw. $B'_2$ transponiert. Das Spiegelfrequenzband umfaßt diejenigen Frequenzen, deren Frequenzabstand vom Träger $f_1$ genauso groß ist wie der Frequenzabstand der Nutzsignale im $B_1$ von diesem Träger. Die niedrigste Spiegelfrequenz ist in Fig. 3a mit $f_{S1}$ bezeichnet. Sie beträgt für das angegebene Beispiel 23,75755 MHz. Das Filter 631 muß daher so ausgelegt sein, daß es das Nutzfrequenzband $B_1$ ungeschwächt durchläßt während es die Frequenz $f_{S1}$ und alle höheren Spiegelfrequenzen unterdrückt. Das Filter ist zu diesem Zweck vorzugsweise als Tiefpaß ausgebildet, dessen Amplitudenfrequenzgang in Fig. 3a durch die gestrichelte Kurve $G_1$ bezeichnet ist.

Das Ausgangssignal der Mischstufe 632 wird über ein als Tiefpaß ausgebildetes Filter 633 einer weiteren Mischstufe 634 zugeführt, in der es mit der zweiten Frequenz $f_2$ gemischt wird. Das Spektrum an den Ein- und Ausgängen dieser Mischstufe ist in Fig. 3b dargestellt - in vergrößertem Maßstab, wie durch die strichpunktierte Linie angedeutet. Analog zur Mischstufe 632 werden auch hier beim Mischvorgang ein Differenzfrequenzband $B_3$ (bei 102,45 KHz) und ein Summenfrequenzband $B'_3$ erzeugt. Die niedrigste Spiegelfrequenz $f_{S2}$ liegt in diesem Fall ($f_2$ = 1,35 MHz) bei 1,42245 MHz. Demgemäß muß der Tiefpaß 633 so aufgebaut sein, daß er das Nutzfrequenzband B2 ungeschwächt durchläßt, während er die Spiegelfrequenz $f_{S2}$ möglichst weitgehend unterdrückt. Der erforderliche Amplitudenfrequenzgang ist in Fig. 3b mit $G_2$ bezeichnet. Durch dieses Tiefpaßfilter wird zugleich das Summenfrequenband $B'_2$ am Ausgang der ersten Mischstufe vollständig unterdrückt.

Das Ausgangssignal der Mischstufe 634 wird über ein Tiefpaßfilter 635 einem Analog-Digital-Wandler 636 zugeführt, dessen Abtastfrequenz $f_T$ 280 KHz beträgt. Nach dem Abtasttheorem kann ein solcher Analog-Digital-Wandler Signale mit einer Frequenz bis zu 140 KHz digitalisieren. Das Band B3 liegt in diesem Frequenzbereich (72,45 KHz bis 132,45 KHz). Signale, deren Frequenz oberhalb der doppelten Abtastfrequenz liegt, werden durch den Abtastprozeß in das Nutzfrequenzband unterhalb von 140 KHz hineingefaltet (aliasing-Effekt) wobei aber ihr Frequenzabstand zur halben Trägerfrequenz erhalten bleibt. Es muß daher die Frequenz $f_{S3}$ (und alle höheren Frequenzen) unterdrückt werden, die oberhalb von 140 KHz den gleichen Frequenzabstand von der halben Trägerfrequenz hat, wie die höchste Frequenz (132,45 KHz) des Nutzbandes; das Tiefpaßfilter 635 muß also die Frequenz $f_{S3}$ = 147,55 KHz und alle höheren Frequenzen unterdrücken. Der dafür erforderliche Frequenzgang ist in Fig. 3 mit $G_3$ bezeichnet.

Das Ausgangssignal des Analog-Digital-Wandlers wird dann in einem Digitalfilter 721 weiterverarbeitet das Teil der Einheit 72 ist. In diesem Filter werden die unterhalb des Nutzfrequenzbandes liegenden Störfrequenzkomponenten unterdrückt, beispielsweise Oberwellen der Netzfrequenz usw.. Nach einer Fouriertransformation des gefilterten digitalisierten Signales kann die weitere Signalverarbeitung in der Einheit 72 in an sich bekannter Weise erfolgen. Die Taktfrequenzen für das Digitalfilter 721 und den Analog-Digital-Wandler 636 sind - ebenso wie die Taktfrequenz für den Signalgenerator 61 - ebenfalls mit der Frequenz des Referenzoszillators synchronisiert.

Es leuchtet ein, daß beispielsweise der Aufwand für das Filter 630 reduziert werden könnte, wenn die erste Frequenz $f_1$ um 250 KHz höher läge; der Abstand zwischen der obersten Frequenz des Nutzbandes $B_1$ und der niedrigsten Spiegelfrequenz $f_{S1}$ wäre dann um 500 KHz größer. Dann würde jedoch das Differenzfrequenzband B2 ebenfalls um 250 KHz höher liegen und dann müßte auch die zweite Frequenz $f_2$ um 250 KHz höher liegen, wenn die Lage des Frequenzbandes B3 unverändert bleiben soll. Das Tiefpaßfilter 633 müßte dann relativ steilere Flanken aufweisen, weil der auf die Frequenz $f_2$ bezogene Frequenzabstand verringert würde. - Auch der Aufwand für das Filter 633 ließe sich verringern, wenn bei unveränderter Lage des Bandes $B_2$ $f_2$ geringfügig vergrößert würde. Dies hätte wiederum eine Verschärfung der Anforderungen an den Tiefpaß 635 zur Folge. Da die Abtastfrequenz des (15 Bit-) Analog-Digital-Wandlers nach oben begrenzt ist, können zwar die Frequenzen $f_1$ und $f_2$ noch frei gewählt werden; jedoch wird dadurch der Aufwand für die Filter 631 bis 635 beeinflußt wie die obigen Überlegungen zeigen.

Die Frequenzen $f_1$ und $f_2$ sind daher so gewählt, daß die relativen Flankensteilheiten aller Filter einander gleich sind. Mit relativer Flankensteilheit wird dabei der Quotient aus der Differenz der (obersten) Nutzfrequenz und der (niedrigsten) Spiegelfrequenz, dividiert durch die Mittenfrequenz ($f_1$, $f_2$ bzw. $f_T/2$) bezeichnet. Dieser Quotient beträgt für die Filter 631, 633 und 635 etwa 0,108. Für eine Unterdrückung der unerwünschten Frequenzen um z.B. 20 db müssen diese Filter von mindestens 22. Ordnung sein. Würde der Aufwand für eines dieser Filter durch Verschiebung der Frequenzen $f_1$ und/oder $f_2$ verändert, müßte der Aufwand für mindestens ein anderes Filter wesentlich erhöht werden, so daß der Gesamtaufwand steigen würde.

Wenn die Frequenz $f_1$ des Ausgangssignal des Synthesizers einen Wert hätte (20,04484 MHz), der genauso weit unter dem Kernresonanzsignal der Spule 5 liegt wie $f_1$ oberhalb der Frequenz dieses Signales liegt, würde das Differenzband $B_2$ seine Lage nicht ändern. In diesem Fall wäre als Filter zur Unterdrückung der Spiegelfrequenzen ein Hochpaß erforderlich. Außerdem würde dann das Frequenzband B3 in der Kehrlage erscheinen, d.h. die höchste Frequenzkomponente des Kernresonanzsignals würde im Band B3 am niedrigsten liegen (und umgekehrt), jedoch könnte dies bei der Weiterverarbeitung des fouriertransformierten Signals berücksichtigt werden.

Wenn die zweite Mischfrequenz ebenfalls entsprechend unterhalb des Bandes $B_2$ erzeugt würde, würde das Band B3 am Eingang des Analog-Digital-Wandlers in Normallage erscheinen. In diesem Fall würde es aber nicht genügen, wenn als Eingangsfilter 633 vor der zweiten Mischstufe ein Hochpaß verwendet würde, weil dieses Filter auch noch das Summenfrequenzband unterdrücken müßte. Endweder müßte das Filter daher als Bandpaßfilter sehr hoher Ordnung ausgebildet sein - was recht aufwendig ist - oder das Summenfrequenzband $B'_2$ am Ausgang der Mischstufe 632 müßte mittels eines zusätzlichen Tiefpasses unterdrückt werden, der aber verhältnismäßig einfach aufgebaut sein könnte.

## Ansprüche

1. Kernresonanz-Spektrometer, bei dem im Empfangszweig zur Umsetzung der Kernresonanzsignale in einen niedrigeren Frequenzbereich wenigstens zwei Mischstufen vorgesehen sind, und bei dem ein Analog-Digital-Wandler die in den niedrigeren Frequenzbereich umgesetzten Kernresonanzsignale in eine Folge von digitalen Datenworten umwandelt, wobei die Abtastfrequenz mindestens doppelt so hoch ist wie die höchste Frequenz in dem umgesetzten Kernresonanzsignal, dadurch gekennzeichnet, daß in der ersten Mischstufe (631) das Kernresonanzsignal mit einer ersten Frequenz ($f_1$) gemischt wird, die in der Nähe der Lamorfrequenz liegt und daß in einer auf die erste Mischstufe folgenden zweiten Mischstufe (633) das Ausgangssignal der ersten Mischstufe mit einer zweiten Frequenz ($f_2$) gemischt wird, die von der Differenzfrequenz abweicht und wesentlich kleiner ist als die erste Frequenz.

2. Spektrometer nach Anspruch 1, dadurch gekennzeichnet, daß im Sendezweig ein Signalgenerator (61) vorgesehen ist, in dem ein Träger mit einer dritten Frequenz moduliert wird, die kleiner ist als die Hälfte der Abtastfrequenz des Analog-Digital-Wandlers (636) und daß das Ausgangssignal des Signalgenerators mit den gleichen Frequenzen ($f_1$, $f_2$) gemischt wird wie das Kernresonanzsignal im Empfangszweig.

3. Spektrometer nach Anspruch 2, dadurch gekennzeichnet, daß die erste und die zweite Frequenz sowie die Abtastfrequenz so gewählt sind, daß der Frequenzabstand zwischen der ersten bzw. der zweiten Frequenz ($f_1$ bzw. $f_2$) und der höchsten noch zu übertragenden Signalfrequenz am Eingang des zugehörigen Mischers, dividiert durch die erste bzw. zweite Frequenz ($f_1$ bzw. $f_2$) zumindest annähernd dem Frequenzabstand zwischen der Hälfte der Abtastfrequenz ($f_r$) und der obersten, vom Analog-Digital-Wandler noch umzusetzenden Signalfrequenz, dividiert durch die Hälfte der Abtastfrequenz, entspricht.

4. Spektrometer nach einem der vorhergehenden Ansprüche, dadurch gekennzeichnet, daß die die erste und die zweite Frequenz ($f_1$, $f_2$) sowie die Abtastfrequenz

(f$_r$) liefernden Generatoren (622, 625, 711) mit einem gemeinsamen Referenzoszillator (626) synchronisiert sind.

5. Kernspintomograph nach Anspruch 2, dadurch gekennzeichnet, daß der Signalgenerator einen Hüllkurvenspeicher (611) aufweist, in dem wenigstens eine Hüllkurve gespeichert ist, sowie einen Sinusspeicher (613) und daß die aus den beiden Speichern entnommenen Signale in einem digitalen Multiplizierer (612) multipliziert werden, wobei das Produktsignal in einem Digital-Analog-Wandler (620) in ein analoges Signal umgesetzt wird, das als Ausgangssignal des Signalgenerators (61) dient.

6. Kernspintomograph nach einem der vorhergehenden Ansprüche, dadurch gekennzeichnet, daß die Mischfrequenzen (f$_1$, f$_2$) höher liegen als die Frequenzen der Nutzsignale (B$_1$, B$_2$), und daß die Filter (631, 633) über die die Nutzsignale den Mischstufen zugeführt werden, als Tiefpässe ausgeführt sind.

EP 0 307 989 A2

Fig.3

Fig.1

1-Ⅱ-PHD 87-178

Fig.2

EP 0 307 989 A2

2-II-PHD 87-178